# EUROPÄISCHE PATENTSCHRIFT

(11) **EP 1 435 107 B1**
(45) Veröffentlichungstag und Bekanntmachung des Hinweises auf die Patenterteilung: **31.03.2010**
(21) Anmeldenummer: 02790287.3
(22) Anmeldetag: 02.10.2002
(51) Int. Cl.: H01L 21/28, H01L 29/423, H01L 29/51

(54) **VERFAHREN ZUM HERSTELLEN EINER GATE-STRUKTUR FUER EINEN MOS-TRANSISTOR**
METHOD FOR PRODUCTION OF A GATE STRUCTURE FOR A MOS TRANSISTOR
PROCEDE DE FABRICATION D'UNE STRUCTURE DE GRILLE DESTINEE A UN TRANSISTOR MOS

(30) Priorität: 08.10.2001 DE 10149541
(43) Veröffentlichungstag der Anmeldung: 07.07.2004
(73) Patentinhaber: Infineon Technologies AG, 81669 München (DE)
(72) Erfinder: HERZUM, Christian, 82343 Pöcking (DE); MÜLLER, Karlheinz, 84149 Velden (DE)
(74) Vertreter: Zimmermann, Tankred Klaus
(86) Internationale Anmeldenummer: PCT/EP2002/011084
(87) Internationale Veröffentlichungsnummer: WO 2003/032378

(56) Entgegenhaltungen:
- US-A- 5 741 737
- US-A- 5 858 844
- US-A- 6 136 657

## Beschreibung

Die vorliegende Erfindung betrifft ein Verfahren zur Herstellung einer Gate-Struktur für einen MOS-Transistor und insbesondere einen MOS-Transistor, dessen Gateoxid zwischen Source-Bereich und Drain-Bereich einen rampenförmigen Verlauf besitzt.

Die Herstellung eines MOS-Transistors erfolgt in bekannter Weise grundsätzlich dadurch, daß auf einem später zwischen einem Source-Bereich und einem Drain-Bereich angeordneten Kanalbereich eine Gate-Struktur erzeugt wird. Zur Erzeugung der Gate-Struktur wird als Dielektrikum eine SiO₂-Schicht (Gateoxid) erzeugt oder abgeschieden, auf der eine Polysiliziumschicht als Gateelektrodenschicht erzeugt wird.

Für bestimmte Anwendungen, beispielsweise LDMOS-Transistoren, kann es von Vorteil sein, daß das Dielektrikum der Gateelektrode, d.h. das Gateoxid, an der Source-Seite eine geringere Dicke aufweist als an der Drain-Seite. Eine solche Struktur ist aus der Schrift US-5,741,737 bekannt. Dies verknüpft die Forderung nach einem niedrigen Widerstand Rₒₙ (d.h. einem möglichst dünnen Gateoxid) auf der Source-Seite und nach einer hohen Spannungsfestigkeit, d.h. einem möglichst dicken Gateoxid, auf der Drain-Seite. Um ein solches Gateoxid zu realisieren, wurde bisher eine "Oxidrampe" hergestellt und anschließend die Gateelektrode auf dieser Rampe justiert. Da dieses Verfahren nicht selbstjustiert ist, ergeben sich Einschränkungen aufgrund der begrenzten Justiermöglichkeiten des Belichtungsequipments für die Strukturierung der abgeschiedenen Polysiliziumschicht, aus der die Gateelektrode erzeugt wird.

Die Aufgabe der vorliegenden Erfindung besteht darin, ein verbessertes Verfahren zur Herstellung einer Gate-Struktur für einen MOS-Transistor zu schaffen, dessen Gateoxid durch eine Oxidrampe gebildet ist.

Diese Aufgabe wird durch ein Verfahren gemäß Anspruch 1 gelöst.

Die vorliegende Erfindung schafft ein Verfahren zur Herstellung einer Gate-Struktur für einen MOS-Transistor, mit folgenden Schritten:
Erzeugen einer Schichtfolge aus einer Oxidschicht, einer Hilfsschicht und einer Maskenschicht auf einem Substrat, wobei die Hilfsschicht und die Maskenschicht strukturiert sind, um eine Kante festzulegen, die einen von diesen Schichten bedeckten Bereich der Oxidschicht von einem freiliegenden Bereich derselben trennt;
Durchführen einer Oxidation zum Erzeugen einer Oxidrampe im Bereich der Kante;
nach dem Erzeugen der Oxidrampe teilweises Entfernen der Hilfsschicht zur Erzeugung eines Hohlraums vorbestimmter Länge zwischen der Oxidschicht und der Maskenschicht; und
Einbringen eines Gateelektrodenmaterials in den Hohlraum zum Erzeugen einer Gateelektrode.

Bei dem erfindungsgemäßen Verfahren entsteht durch den Schritt des Oxidierens an der Kante der Hilfsschicht, die an die Oxidschicht grenzt, ein sogenannter Vogelschnabel, d.h. ein Bereich mit stetig ansteigender Oxiddicke, der auch als Oxidrampe bezeichnet werden kann. Die vorliegende Erfindung nutzt nun die Tatsache aus, daß die Oxidrampe zumindest teilweise unter der Hilfsschicht und der Maskenschicht, die die Oxidschicht bedecken, erzeugt wird, um eine selbstjustierte Erzeugung einer Gateelektrodenschicht zu realisieren. Zu diesem Zweck wird die Kante sozusagen als "Justiermerkmal" verwendet, indem ausgehend von der Kante durch Entfernen der Hilfsschicht ein Hohlraum vorbestimmter Länge erzeugt wird, in den das Gateelektrodenmaterial eingebracht wird, um die Gateelektrode zu erzeugen. Somit ist die Gateelektrode relativ zu der Kante und somit relativ zu der Oxidrampe, die eine definierte Positionsbeziehung bezüglich der Kante aufweist, justiert.

Gemäß der vorliegenden Erfindung wird somit die Gateelektrode selbstjustiert erzeugt, so daß im Gegensatz zum Stand der Technik die Justierung nicht durch eine Strukturierung einer vollständig aufgebrachten Gateelektrodenschicht mit den dabei vorliegenden begrenzten Justiermöglichkeiten erfolgen muß. Somit kommt das erfindungsgemäße Verfahren ohne zusätzliche Maskenschritte und Lithographieschritte zur Justierung aus. Ferner kann mit dem erfindungsgemäßen Verfahren eine sehr genaue Justierung bewirkt werden, deren Genauigkeit nicht durch Einschränkungen hinsichtlich der begrenzten Justiermöglichkeiten des Belichtungsequipments beeinträchtigt ist.

Erfindungsgemäß wird das Gateelektrodenmaterial vorzugsweise in den taschenförmigen Hohlraum unter der Maskenschicht eingebracht, indem zunächst eine Gateelektrodenmaterialschicht vollflächig auf die Struktur aufgebracht wird, wobei dieses Material auch in den genannten Hohlraum eindringt und diesen ausfüllt. Nachfolgend wird die vollflächig aufgebrachte Schicht selektiv entfernt, so daß der in dem Hohlraum befindliche Teil des Gateelektrodenmaterials als Gateelektrode verbleibt.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:

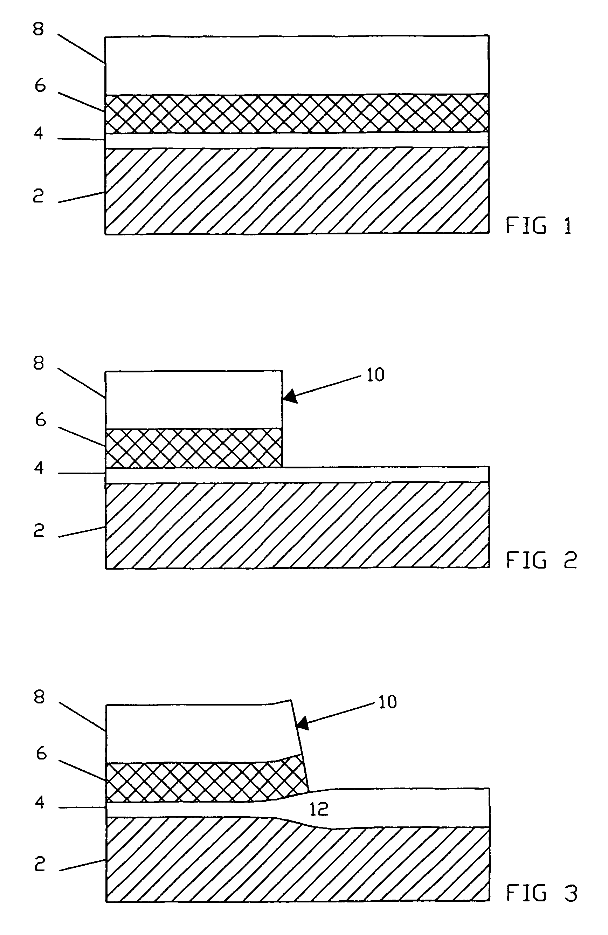

Fig. 1 bis 8 Querschnittansichten verschiedener Verfahrensstadien eines bevorzugten Ausführungsbeispiels des erfindungsgemäßen Verfahrens.

Bei dem bevorzugten Ausführungsbeispiel des erfindungsgemäßen Verfahrens wird zunächst auf ein Ausgangsmaterial, bei dem es sich vorzugsweise um ein Siliziumsubstrat 2 handelt, eine untere Siliziumoxidschicht (SiO₂) 4 aufgebracht. Auf die untere Siliziumoxidschicht 4 wird eine Siliziumnitridschicht (Si₃N₄) 6 aufgebracht, auf die wiederum eine obere Siliziumoxidschicht (SiO₂) 8 aufgebracht wird. Die Oxidschicht 4 kann beispielsweise durch eine thermische Oxidation erzeugt werden, während die Siliziumnitridschicht 6 bzw. die Siliziumoxidschicht 8 z.B. in bekannter Weise aus der Gasphase erzeugt bzw. abgeschieden werden können. Die sich ergebende Struktur ist in Fig. 1 dargestellt.

Nachfolgend werden die obere Oxidschicht 8 und die Siliziumnitridschicht 6 durch einen Lithographieschritt und eine anschließende Ätzung strukturiert, um eine Kante in denselben zu definieren, die einen Bereich der Oxidschicht 4, der von diesen beiden Schichten 6 und 8 bedeckt ist, von einem freigelegten Bereich der Oxidschicht 4 trennt, wie in Fig. 2 dargestellt ist. Nach dem Strukturieren der Schichten 6 und 8 wird eine Oxidation durchgeführt, wodurch sich die Dicke der freigelegten SiO₂-Schicht 4 erhöht. An der Kante 10 der zuvor strukturierten Nitridschicht 4 entsteht ein sogenannter Vogelschnabel 12, d.h. ein Bereich mit stetig ansteigender Oxiddicke, der auch als Oxidrampe 12 bezeichnet werden kann. Die Form dieser Oxidrampe kann durch die Dicke der Oxidschicht 4, die Dicke der Nitridschicht 6 sowie die Verfahrensparameter bei der durchgeführten Oxidation beeinflußt werden.

Bei dem Oxidationsprozeß entsteht auch auf der Stirnfläche der Nitridschicht 6 an der Kante 10 eine nicht dargestellte Nitridoxid-Schicht, die nach der Oxidation durch eine sehr kurze Oxidätzung entfernt wird.

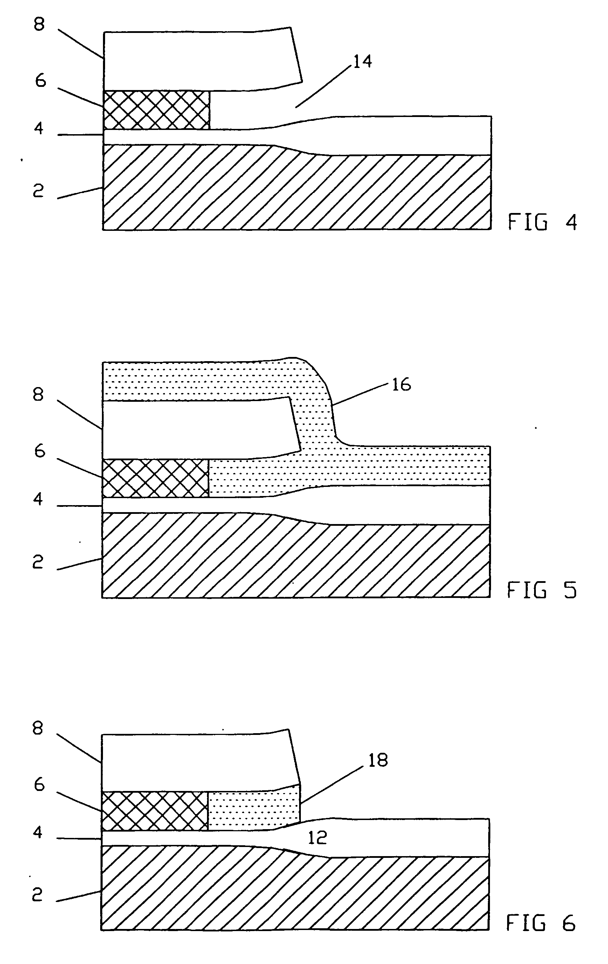

Nach der Erzeugung des Vogelschnabels bzw. der Oxidrampe 12 wird die Nitridschicht 6 selektiv naßchemisch zurückgeätzt, um unterhalb der als Maskenschicht dienenden oberen Oxidschicht 8, d.h. zwischen der oberen Oxidschicht 8 und der unteren Oxidschicht 4 einen Hohlraum 14 zu erzeugen. Die Tiefe des Hohlraums 14, die der Gatelänge entspricht, kann durch entsprechende Wahl der Ätzparameter eingestellt werden. Die sich ergebende Struktur mit dem taschenförmigen Hohlraum 14 ist in Fig. 4 gezeigt.

Nach der Erzeugung des Hohlraums 14 wird unter Verwendung herkömmlicher Verfahren eine Polysiliziumschicht 16 konform auf der Struktur, die in Fig. 4 gezeigt ist, abgeschieden. Wie in Fig. 5 gezeigt ist, bedeckt die erzeugte Polysiliziumschicht 16 die gesamte Oberfläche der Struktur und füllt ferner den Hohlraum 14 vollständig aus.

In einen nachfolgenden Verfahrensschritt wird die Polysiliziumschicht 16 anisotrop und selektiv zu Siliziumoxid zurückgeätzt, wodurch dieselbe mit Ausnahme der in dem Hohlraum 14 befindlichen Teile vollständig entfernt wird. Dadurch wird aus der Polysiliziumschicht 16 eine in den Hohlraum 14 eingebrachte Gateelektrode 18 erzeugt, wie in Fig. 6 gezeigt ist. Auf Grund der Tatsache, daß der Hohlraum 14 eine feste räumliche Beziehung zu der Kante 10 aufweist und die Kante 10 eine feste räumliche Beziehung zu der Oxidrampe 12 besitzt, ist die in dem Hohlraum gebildete Gateelektrode 18 bezüglich der Oxidrampe 12 justiert.

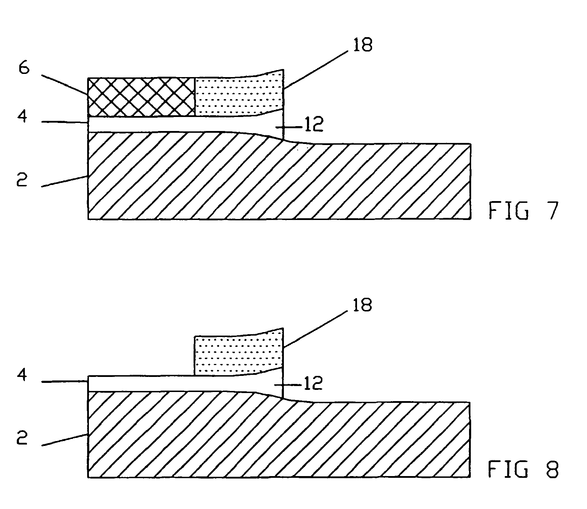

Bei dem gezeigten bevorzugten Ausführungsbeispiel wird nachfolgend die Siliziumoxidschicht 8 anisotrop und selektiv zu Silizium zurückgeätzt, wobei die sich ergebende Struktur in Fig. 7 gezeigt ist. Nachfolgend wird die als Hilfsschicht dienende Siliziumnitridschicht selektiv zu Silizium und selektiv zu Siliziumoxid geätzt, so daß sich die in Fig. 8 gezeigte Gate-Struktur ergibt. Diese Schritte des selektiven Entfernens von Siliziumoxidschicht 8 und Siliziumnitridschicht 6 sind optional, abhängig davon, wie die Gateelektrode kontaktiert werden soll.

Die in Fig. 8 gezeigte Struktur kann nun als Ausgangsbasis für die Erzeugung eines MOS-Transistors dienen. An dieser Stelle sei angemerkt, daß prozeßabhängig Schritte zur Erzeugung der übrigen Transistorstrukturen, wie beispielsweise der Drain-Bereiche oder Source-Bereiche, bereits vor oder während der Durchführung des erfindungsgemäßen Verfahrens zur Erzeugung einer Gate-Struktur durchgeführt werden können.

Die zur Durchführung des erfindungsgemäßen Verfahrens erforderlichen Prozeßschritte können sämtlich mittels herkömmlicher Techniken durchgeführt werden, wobei die Wahl geeigneter Abscheidungsverfahren zum Aufbringen der einzelnen Schichten, geeigneter Strukturierungsverfahren, geeigneter Ätzmittel sowie weiterer geeigneter Verfahrensparameter für einen Fachmann offensichtlich sind. Ferner ist klar, daß die oben bezüglich des bevorzugten Ausführungsbeispiels beschriebenen Materialien lediglich beispielhafter Natur sind und andere Materialien mit gleichartigen Eigenschaften statt der beschriebenen verwendet werden können. Beispielsweise kann statt eines Siliziumsubstrats ein Siliziumkarbidsubstrat (SiC) als Substrat 2 verwendet werden.

### Bezugszeichenliste

| | |
|---|---|
| 2 | Siliziumsubstrat |
| 4 | Untere Siliziumoxidschicht |
| 6 | Siliziumnitridschicht |
| 8 | Obere Siliziumoxidschicht |
| 10 | Kante |
| 12 | Oxidrampe |
| 14 | Hohlraum |
| 16 | Polysiliziumschicht |
| 18 | Gateelektrode |

## Patentansprüche

1. Verfahren zur Herstellung einer Gate-Struktur für einen MOS-Transistor mit folgenden Schritten:
Erzeugen einer Schichtfolge aus einer Oxidschicht (4), einer Hilfsschicht (6) und einer Maskenschicht (8) auf einem Substrat (2), wobei die Hilfsschicht (6) und die Maskenschicht (8) strukturiert sind, um eine Kante (10) festzulegen, die einen von diesen Schichten bedeckten Bereich der Oxidschicht (2) von einem freiliegenden Bereich derselben trennt;
Durchführen einer Oxidation zum Erzeugen einer Oxidrampe (12) im Bereich der Kante (10);
nach dem Erzeugen der Oxidrampe (12), teilweises Entfernen der Hilfsschicht (6) zur Erzeugung eines Hohlraums (14) vorbestimmter Länge zwischen der Oxidschicht (4) und der Maskenschicht (8); und
Einbringen eines Gateelektrodenmaterials in den Hohlraum (14) zum Erzeugen einer Gateelektrode (18).

2. Verfahren nach Anspruch 1, bei dem das Substrat (2) ein Siliziumsubstrat, die Oxidschicht (4) eine Siliziumoxidschicht, die Hilfsschicht (6) eine Siliziumnitridschicht und die Maskenschicht (8) eine Siliziumoxidschicht ist.

3. Verfahren nach einem der Ansprüche 1 oder 2, bei dem das Gateelektrodenmaterial Polysilizium ist.

4. Verfahren nach einem der Ansprüche 1 bis 3, das ferner einen Schritt des Entfernens eines bei der Oxidation auf einer an der Kante (10) befindlichen Seitenwand der Hilfsschicht (6) gebildeten Oxids vor dem teilweisen Entfernen der Hilfsschicht (6) aufweist.

5. Verfahren nach Anspruch 4, bei dem das Oxid auf der Seitenwand der Hilfsschicht (6) durch eine Oxidätzung entfernt wird.

6. Verfahren nach einem der Ansprüche 1 bis 5, bei dem die Hilfsschicht (6) zur Erzeugung des Hohlraums (14) selektiv naßchemisch zurückgeätzt wird.

7. Verfahren nach einem der Ansprüche 1 bis 6, bei dem das Einbringen des Gateelektrodenmaterials in den Hohlraum folgende Schritte aufweist:
Aufbringen einer Gateelektrodenmaterialschicht (16) auf die nach der Erzeugung des Hohlraums (14) vorliegende Struktur, wobei dabei auch der Hohlraum (14) mit dem Gateelektrodenmaterial ausgefüllt wird; und
anisotropes und selektives Zurückätzen der Gateelektrodenmaterialschicht außerhalb des mit dem Gateelektrodenmaterial gefüllten Hohlraums.

8. Verfahren nach einem der Ansprüche 1 bis 7, das fernen einen Schritt des Entfernens zumindest der Maskenschicht (8) zum Freilegen der Gateelektrode (18) aufweist.

9. Verfahren nach Anspruch 8, bei dem der Schritt des Entfernens zumindest der Maskenschicht einen Schritt des anisotropen und selektiven Zurückätzens der Maskenschicht (8) aufweist.

10. Verfahren nach Anspruch 8 oder 9, das ferner einen Schritt des anisotropen und selektiven Zurückätzens der Hilfsschicht (6) umfaßt.

## Claims

1. A method for producing a gate structure for an MOS transistor, comprising:
generating a layer sequence of an oxide layer (4), an auxiliary layer (6) and a masking layer (8) on a substrate (2), wherein the auxiliary layer (6) and the masking layer (8) are structured to determine an edge (10) separating an area of the oxide layer (4) covered with these layers from an exposed area thereof;
performing an oxidation to generate an oxide ramp (12) in the area of the edge (10);
after generating the oxide ramp (12), partly removing the auxiliary layer (6) to generate a hollow space (14) of a predetermined length between the oxide layer (4) and the masking layer (8); and
introducing a gate electrode material into the hollow space (14) to generate a gate electrode (18).

2. The method according to claim 1, wherein the substrate (2) comprises a silicon substrate, the oxide layer (4) comprises a silicon oxide layer, the auxiliary layer (6) comprises a silicon nitride layer and the masking layer (8) comprises a silicon oxide layer.

3. The method according to one of claims 1 or 2, wherein the gate electrode material comprises polysilicon.

4. The method according to one of claims 1 to 3, further comprising the step of removing an oxide formed during the oxidation on a sidewall of the auxiliary layer (6), which is located at the edge (10), prior to partly removing the auxiliary layer (6).

5. The method according to claim 4, wherein the oxide on the sidewall of the auxiliary layer (6) is removed by an oxide etching.

6. The method according to one of claims 1 to 5, wherein the auxiliary layer (6) is etched back selectively wet-chemically for generating the hollow space (14).

7. The method according to one of claims 1 to 6, wherein introducing the gate electrode material into the hollow space comprises:
depositing a gate electrode material layer (16) on the structure present after generating the hollow space (14), wherein the hollow space (14) is also filled in with the gate electrode material; and
anisotropically and selectively back-etching the gate electrode material layer outside the hollow space filled with gate electrode material.

8. The method according to one of claims 1 to 7, further comprising a step of removing at least the masking layer (8) for exposing the gate electrode (18).

9. The method according to claim 8, wherein the step of removing at least the masking layer comprises a step of anisotropically and selectively back-etching the masking layer (8).

10. The method according to claim 8 or 9, further comprising a step of anisotropically and selectively back-etching the auxiliary layer (6).

## Revendications

**1.** Procédé de fabrication d'une structure de grille destinée à un transistor MOS, aux étapes suivantes consistant à:
générer une succession de couches composée d'une couche d'oxyde (4), d'une couche auxiliaire (6) et d'une couche de masque (8) sur un substrat (2), la couche auxiliaire (6) et la couche de masque (8) étant structurées, pour fixer un bord (10) qui sépare une zone, recouverte par ces couches, de la couche d'oxyde (2) d'une zone libre de cette dernière;
réaliser une oxydation, pour générer une rampe d'oxyde (12) à l'endroit du bord (10);
après génération de la rampe d'oxyde (12), éliminer partiellement la couche auxiliaire (6), pour générer un espace creux (14) de longueur prédéterminée entre la couche d'oxyde (4) et la couche de masque (8); et
introduire un matériau d'électrode de grille dans l'espace creux (14), pour générer une électrode de grille (18).

**2.** Procédé selon la revendication 1, dans lequel le substrat (2) est un substrat de silicium, la couche d'oxyde (4) est une couche d'oxyde de silicium, la couche auxiliaire (6) est une couche de nitrure de silicium et la couche de masque (8) est une couche d'oxyde de silicium.

**3.** Procédé selon l'une des revendications 1 ou 2, dans lequel le matériau d'électrode de grille est du polysilicium.

**4.** Procédé selon l'une des revendications 1 à 3, présentant par ailleurs une étape consistant à éliminer un oxyde formé, lors de l'oxydation, sur une paroi latérale de la couche auxiliaire (6) se trouvant au bord (10), avant l'élimination partielle de la couche auxiliaire (6).

**5.** Procédé selon la revendication 4, dans lequel l'oxyde sur la paroi latérale de la couche auxiliaire (6) est éliminé par une gravure d'oxyde.

**6.** Procédé selon l'une des revendications 1 à 5, dans lequel la couche auxiliaire (6) est sélectivement gravée en retrait par un procédé chimique humide, pour générer l'espace creux (14).

**8.** Procédé selon l'une des revendications 1 à 6, dans lequel l'introduction du matériau d'électrode de grille dans l'espace creux présente les étapes suivantes consistant à:
appliquer une couche de matériau d'électrode de grille (16) sur la structure présente après génération de l'espace creux (14), l'espace creux (14) étant ainsi également rempli du matériau d'électrode de grille; et
graver en retrait de manière anisotrope et sélective la couche de matériau d'électrode de grille en-dehors de l'espace creux rempli du matériau d'électrode de grille.

**8.** Procédé selon l'une des revendications 1 à 7, présentant par ailleurs une étape consistant à éliminer au moins la couche de masque (8), pour dégager l'électrode de grille (18).

**9.** Procédé selon la revendication 8, dans lequel l'étape consistant à éliminer au moins la couche de masque présente une étape consistant à graver en retrait de manière anisotrope et sélective la couche de masque (8).

**10.** Procédé selon la revendication 8 ou 9, comportant par ailleurs une étape consistant à graver en retrait de manière anisotrope et sélective la couche auxiliaire (6).
